# EUROPEAN PATENT APPLICATION

(11) **EP 1 652 869 A1**
(43) Date of publication of application: **03.05.2006**
(21) Application number: 04771487.8
(22) Date of filing: 04.08.2004
(51) Int. Cl.: C08G 59/40

(54) **EPOXY RESIN COMPOSITION AND METHOD FOR PRODUCING HEAT-RESISTANT LAMINATE SHEET**

(30) Priority: 05.08.2003 JP 2003206012
(71) Applicant: KAWAMURA INSTITUTE OF CHEMICAL RESEARCH, Sakura-shi Chiba 285-0078 (JP)
(72) Inventor: OHBAYASHI, Akira, Sakura-shi, Chiba 285-0817 (JP); HARAGUCHI, Kazutoshi, Chiba-shi, Chiba 263-0001 (JP)
(74) Representative: Albrecht, Thomas
(86) International application number: PCT/JP2004/011502
(87) International publication number: WO 2005/012385

(57) **Abstract**

An epoxy resin composition comprising, as essential components, an epoxy resin having two or more epoxy groups in the molecule, and a polyamine borate as a curing agent for the epoxy resin, whrein the polyamine borate is obtained from a polyamine-based compound (A) having at least one of amino group and imino group in the molecule and a boric acid-based compound (B) represented by the following general formula (1):

B(OR)ₙ(OH)₃₋ₙ (1)

wherein n represents an integer of 0 to 3, R represents an alkyl group represented by CₘH₂ₘ₊₁, and m represents an integer of 1 to 10.

## Description

### TECHNICAL FIELD

The present invention relates to an epoxy resin composition containing a polyamine borate, and a method for producing a heat-resistant laminate sheet using the same.

### BACKGROUND ART

A reaction product of a boric acid and an amine compound such as monoamine or diamine has been studied for a long time (see Japanese Examined Patent Application, Second Publication No. Sho 54-4377 and Japanese Unexamined Patent Application, First Publication No. Hei 4-338355). In these documents, an aqueous solution obtained by reacting an amine compound with boric acid is used as a coagulating agent of a latex or a catalyst for the production of an α-alkylacrolein as it is. There has recently been reported an example in which the aqueous solution is used as a component of a cement composition (see Published Japanese Translation of No. 2003-504294 of the PCT Application and specification of U.S. Patent No. 6,133,347).

The requirement for heat resistance of an epoxy resin used in various industrial fields is becoming more strict. As effective methods for improving heat resistance, a curing agent can be selected. As a curing agent for epoxy resin, an amine compound is used most popularly. However, a resin cured article obtained by using an amine-based curing agent has a glass transition temperature (Tg) of about 150°C at the highest and is not sufficient in heat resistance. Furthermore, most amine compounds have irritating odor and may cause problems such as safety in handling.

It is known from Japanese Unexamined Patent Application, First Publication No. Hei 4-227924, specification of U.S. Patent No. 5,169,473 and WO03/037985 that, when amine compound is used as a curing agent in an epoxy resin, boric acid is used in combination as an additive such as curing inhibitor. In such a case, there is a problem that the amine compound tends to have toxicity and also some amine compound has strong odor and therefore it is not easy to handle. Furthermore, when a small amount of boric acid is added, the resulting cured article is insufficient in heat resistance. On the other hand, a large amount of boric acid is added, the resulting cured article is inferior in storage stability and has low Tg, for example, subpeak of tan δ of the cured article appears at 107°C and thus an adverse influence is exerted on characteristics of the cured article.

There is also reported a method for producing a laminate, wherein a composition comprising an epoxy resin, an organic phosphorus-based compound as a curing agent and a monoamine borate as a curing accelerator is used (see specification of U.S. Patent No. 3,738,862). However, since the monoamine borate used does not act as a curing agent, the resulting cured article had not remarkably improved heat resistance.

There is also known a sealing agent for tape carrier package, which contains an epoxy resin, a phenol novolak resin as a curing agent and 2-ethyl-4-methylimidazole· tetraphenylborate as a curing accelerator (Japanese Unexamined Patent Application, First Publication No. Hei 11-343392). The 2-ethyl-4-methylimidazole·tetraphenyl borate does not contributes to an improvement in heat resistance of a cured article obtained from a composition because tetraphenyl borate is obtained by bonding a boron atom with a phenyl group through no oxygen atom.

### DISCLOSURE OF THE INVENTION

The present inventors have intensively studied so as to achieve the objects described above and found that borate groups are introduced into an epoxy resin in a molecular level by using a polyamine borate obtained by reacting a polyamine-based compound with an inexpensive boric acid or boric acid ester as a curing agent for epoxy resin, and thus a cured article having high heat resistance, that is, high glass transition temperature can be obtained. Consequently, the present invention has been completed.

The present invention is directed to an epoxy resin composition comprising, as essential components, an epoxy resin having two or more epoxy groups in the molecule and a polyamine borate as a curing agent for the epoxy resin, wherein the polyamine borate is obtained from a polyamine-based compound (A) having at least one of amino group and imino group in the molecule and a boric acid-based compound (B) represented by the following general formula (1):

B(OR)ₙ(OH)₃₋ₙ (1)

wherein n represents an integer of 0 to 3, R represents an alkyl group represented by CₘH₂ₘ₊₁, and m represents an integer of 1 to 10.

### BRIEF DESCRIPTION OF THE DRAWINGS

Fig. 1 is a graph showing temperature variance of tan δ and a storage elastic modulus (E') of epoxy resin cured articles obtained in Example 1 and Comparative Example 1.
Fig. 2 is a graph showing temperature variance of tan δ and a storage elastic modulus (E') of an epoxy resin cured article obtained in Example 12.

### BEST MODE FOR CARRYING OUT THE INVENTION

Preferred examples of the present invention will now be described. The present invention is not limited to the following respective examples and, for example, constituent elements of these examples may be appropriately combined with each other.

An object of the present invention is to provide a epoxy resin composition which is capable of providing a cured article having high glass transition temperature (Tg) and has reduced irritating odor and is easily handled, and is also excellent in heat resistance and flame retardancy, and a method for producing the same.

Another object of the present invention is to provide a method for producing a heat-resistant laminate sheet, which is particularly useful for a copper-cladded laminate, using the resin composition. The resent invention is also directed to a method for producing a heat-resistant laminate sheet, which is useful for a copper-cladded laminate, comprising: forming an uncured coating film layer of the epoxy resin composition on the surface of a substrate sheet; laying another heat-resistant substrate sheet on the uncured coating film layer; and curing the uncured coating film layer after thermal contact bonding of both substrate sheets.

The epoxy resin in the present invention is a conventional epoxy resin having two or more epoxy groups on average in a molecule and the kind is not specifically limited. For example, the following various epoxy resins can be used alone or in combination.
(1) Phenol-based glycidyl ether type epoxy resin:
   phenol-based glycidyl ether type epoxy resin obtained by reacting a phenol compound such as bisphenol-A, bisphenol-F, tetrabromobisphenol-A, tetraphenylolethane, phenyl novolak or cresol novolak with epichlorohydrin
(2) Alcohol-based glycidyl ether type epoxy resin:
   alcohol-based glycidyl ether type epoxy resin obtained by reacting (a) a polyol obtained by the addition reaction of a phenol compound such as bisphenol-A, bisphenol-F, tetrabromobisphenol-A or tetraphenylolethane and an alkylene oxide, or a polyol such as hydrogenated bisphenol A, with (b) epichlorohydrin
(3) Glycidyl ester type epoxy resin:
   diglycidyl ester type epoxy resin such as hexahydrophthalic acid diglycidyl ester or dimer acid glycidyl ester
(4) Glycidylamine type epoxy resin:
   glycidylamine type epoxy resin such as 1,3-diglycidyl hydantoin, triglycidyl isocyanurate, tetraglycidyl diaminodiphenylmethane or triglycidyl-paraaminophenol
(5) Mixed type epoxy resin:
   mixed type epoxy resin such as epoxy resin obtained by reacting aminophenol or oxybenzoic acid with epichlorohydrin, an alicyclic type epoxy resin having a cyclopentadiene or dicyclopentadiene skeleton, or a brominated epoxy resin

In the present invention, in order to impart sufficiently high glass transition temperature and excellent mechanical properties to the cured article of the epoxy resin composition, an epoxy group equivalent of the epoxy resin is preferably from 100 to 1000, more preferably from 110 to 800, and particularly preferably from 120 to 500.

The polyamine borate used as the curing agent for epoxy resin in the present invention is obtained from a polyamine-based compound (A) having at least one of amino group and imino group in a molecule, and a boric acid-based compound (B) represented by the general formula (1):

B(OR)ₙ(OH)₃₋ₙ (1)

Wherein n represents an integer of 0 to 3, R represents an alkyl group represented by CₘH₂ₘ₊₁, and m represents an integer of 1 to 10.

For example, the polyamine borate may be a powdered polyamine borate free from an amine irritating odor, which is obtained by removing a solvent from a reaction product obtained by reacting a polyamine-based compound (A) with a boric acid-based compound (B) in a solvent or water, and optionally isolating or purifying the reaction product.

The polyamine-based compound (A) used in the present invention may be a polyamine compound having at least one of amino group and imino group in the molecule, capable of curing the epoxy resin. The phrase "having at least one amino group amd imino group in the molecule" means that the polyamine-based compound can have at least one amino group and/or at least one imino group in the molecule and may have one or more kinds of the group. The polyamine-based compound is preferably an aliphatic polyamine, an aromatic polyamine or an alicyclic polyamine, and may have a nitrilo group in the molecule.

A general formula of a typical polyamine-based compound (A) to be used is shown below.

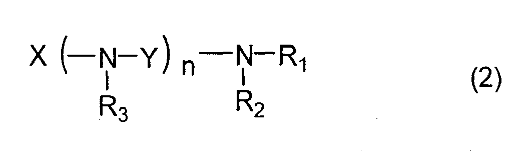

In the general formula (2), R₁, R₂ and R₃ represent hydrogen, an alkyl group having 1 to 20 carbon atoms, or an alkanol group having 1 to 20 carbon atoms. X represents hydrogen, an alkyl group having 1 to 20 carbon atoms, an alkanol group having 1 to 20 carbon atoms, or an oxyalkylene group having 2 to 50 carbon atoms. Provided that at least one of R₁, R₂, R₃ and X is hydrogen. Y represents a phenyl group, or an alkylene or alkyleneether group having 2 to 50 carbon atoms, and n represents an integer of 1 to 5.

Examples of the polyamine-based compound (A) also includes an imidazole compound represented by the general formula (3).

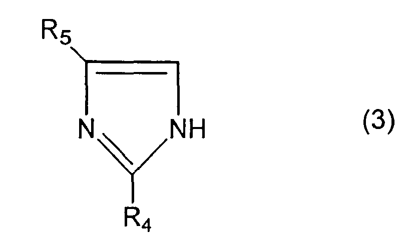

In the general formula (3), R₄ represents methyl group, ethyl group, isopropyl group, alkyl group having 11 carbon atoms, alkyl group having 17 carbon atoms, phenyl group, or the like and R₅ represents hydrogen, methyl group or the like.

Specific examples of the polyamine-based compound (A) include the followings.
(1) Aliphatic polyamine:
   ethylenediamine, diethylenetriamine, triethylenetetramine, tetraethylenepentamine, pentaethylenehexamine, propylenediamine, dipropylenetriamine, cyclohexanediamine, hexamethylenediamine, triethylenediamine, 2,5-dimethylhexamethylenediamine, trimethylhexamethylenediamine, or bis(hexamethylene)triamine.
(2) Alicyclic polyamine:
   metathene diamine, isophoronediamine, N-aminoethylpiperazine, bis(4-amino-3-methylcyclohexyl)methane, bis(4-aminocyclohexyl)methane, or 1,3,5-tris(aminomethyl)benzene
(3) Aromatic polyamine:
   m-phenylenediamine, metaxylenediamine, diaminodiphenylmethane, or diaminodiphenylsulfone
(4) Polyamideamine:
   Polyamideamine produced by reacting an aliphatic polyamine with a polymerized fatty acid or benzoic acid, for example, RACCAMIDE TD-984 and EPICLON B-053 (both are manufactured by DAINIPPON INK AND CHEMICALS, INCORPOREATED)
(5) Secondary amine compound:
   N-methylpiperazine or hydroxyethylpiperazine
(6) Imidazole compound:
   2-methylimidazole, 2-ethyl-4-methylimidazole, 2-undecylimidazole, 2-heptadecylimidazole, 2-phenylimidazole, 1-benzyl-2-methylimidazole, or 1-cyanoethyl-2-methylimidazole
(7) Dicyandiamide
   The boric acid-based compound (B) used in the present invention may be boric acid, boric acid ester or partial polycondensate of boric acid ester represented by the general formula (1):

   B(OR)ₙ(OH)₃₋ₙ (1)

   wherein n represents an integer of 0 to 3, R represents an alkyl group represented by CₘH₂ₘ₊₁, and m represents an integer of 1 to 10.

Specific examples of the boric acid include orthoboric acid, metaboric acid, tetraboric acid, and a mixture thereof. Specific examples of the boric acid ester include trimethyl borate, triethyl borate, tripropyl borate and tributyl borate. These boric acids and boric acid esters can be used alone or in combination of two or more. Also partial hydrolyzates and partial polycondensates thereof can be used. Among these, boric acid is used most preferably.

The partial polycondensate can be obtained by mixing the boric acid ester represented by the general formula (1), water, a solvent and, if necessary, an acid or basic catalyst with stirring.

Specific examples of the polyamine borate obtained by reacting the polyamine-based compound and the boric acid-based compound, which are represented by the above general formulas, include aliphatic polyamine borates such as ethylenediamine borate, diethylenetriamine borate, triethylenetetramine borate and tetraethylenepentamine borate. In case of small molecular ethylenediamine or diethylenetriamine, crystalline and noncrystalline polyamine borates can be produced, separately. Both polyamine borates are used as the polyamine borate which is effective in the present invention.

When the solvent such as N,N-dimethylformamide is used as a synthetic solvent, a crystalline polyamine borate can be obtained. To the contrary, when water is used as the synthetic solvent, a noncrystalline polyamine borate can be obtained. In case of the noncrystalline polyamine borate, it was observed that a signal of ¹¹B-NMR shifts to the lower magnetic field as compared with the crystalline polyamine borate and an absorption of stretching vibration of a B-O bond in FT-IR shifts to the lower frequency side as compared with the crystalline polyamine borate, and thus this fact suggested that a borate group has a different chemical structure.

Furthermore, since the measured value of the boron content in crystalline and noncrystalline polyamine borates is higher than the boron content of the mononuclear borate, it is assumed that a main component of the resulting aliphatic polyamine borates are a polynuclear condensed borate. Furthermore, as a result of X-ray structural analysis of a single crystal obtained by dissolving the crystalline ethylenediamine borate in methanol and cooling overnight, it was found that the single crystal has a structure corresponding to that of a mononuclear borate represented by the following formula (4). It is considered that this mononuclear borate is obtained by esterification of the mononuclear borate represented by the formula (5), and it was concluded that the mononuclear borate represented by the formula (5) is also included in the crystalline ethylenediamine borate.

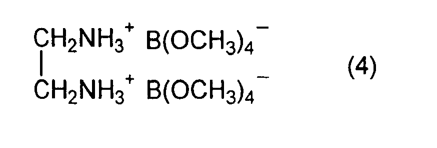

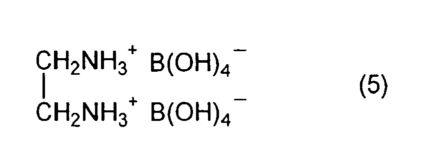

When large molecular triethylenetetramine or tetraethylenepentamine is used, only a noncrystalline polyamine borate can be obtained even if the synthetic solvent is a solvent such as N,N-dimethylformamide. From the measured boron content and amine content, it was concluded that a main component of the polyamine borate is a polynuclear condensed borate.

Another specific examples of the polyamine borate of the present invention include polyamideamine borate. When using polyamideamine, crystalline and noncrystalline polyamideamine borates can be produced, separately, according to a molar ratio of amine to boric acid. For example, when 1 or more mols of boric acid is charged based on 1 mol of an amino group and an imino group in amine, a crystalline polyamideamine borate is obtained. On the other hand, when the amount of boric acid is less than 0.6 mols based on 1 mol of an amino group and an imino group, a noncrystalline polyamideamine borate is obtained. From the measurement of the boron content, it was found that a main component of the crystalline polyamideamine borate is a polynuclear condensed borate.

Specific examples of the imidazole borate include 2-ethyl-4-methylimidazole borate. From a pattern of X-ray diffraction and the measured value of the boron content, it was found that a crystalline imidazole condensed borate was obtained.

For example, the polyamine borate in the present invention can be synthesized in the following manner. After dissolving or suspended boric acid in a solvent or water, a polyamine-based compound solution is added dropwise while stirring. In some case, a boric acid solution may be added dropwise while stirring a solvent solution or an aqueous solution of a polyamine-based compound. Subsequently, the reaction is carried out at room temperature or while heating for a fixed time. Consequently, a polyamine borate is precipitated and the precipitate (polyamine borate) is collected by suction filtration. In some case, the reaction product is dissolved in the reaction solvent. In that case, the polyamine borate is obtained by distilling off the solvent using an evaporator. The reaction product thus obtained is repeatedly washed several times with N,N-dimethylformamide, acetone or the like and then vacuum-dried to obtain an amine borate as a white powder.

As a synthetic solvent of the polyamine borate in the present invention, a solvent, which dissolves at least one of a boric acid-based compound and a polyamine-based compound, is required. Specific examples of the solvent include lower alcohol such as methanol, ethanol or isopropanol, acetone, methyl ethyl ketone, tetrahydrofuran, N,N-dimethylformamide, N-methyl pyrrolidone, N,N-dimethylacetamide, dimethyl sulfoxide, and water, and these solvents can be used alone or in combination. Among these solvents, N,N-dimethylformamide or water is used particularly preferably. The amount of the solvent used is from 300 to 1500 parts by mass based on 100 parts by mass of the total of the boric acid-based compound and the polyamine-based compound.

As the conditions in the synthesis of the polyamine borate in the present invention, a molar ratio of a nitrogen-containing group in the polyamine-based compound to boron of the boric acid-based compound is important. When the content of the boric acid-based compound increases, the polynuclear condensed borate is easily formed and a polyamine borate having high boron content is obtained. On the other hand, when the content of the polyamine-based compound increases, an amine borate having lower boron content can be obtained. The content of boron of said compound is preferably from 0.25 to 10 mols, more preferably from 0.5 to 8 mols, and particularly preferably from 1 to 6 mols, based on 1 mol of a nitrogen-containing group in the polyamine-based compound, that is, the total of an amino group, an imino group and a nitrilo group. When the content of boron is less than 0.25 mols or more than 10 mols, yield of the polyamine borate is low and it becomes disadvantageous economically, and thus it is not preferable. The reaction temperature varies depending on the kind of the polyamine-based compound used, but is preferably from 15°C to 150°C, more preferably from 20°C to 120°C, and particularly preferably from 25°C to 100°C. The reaction time varies depending on the reaction temperature, but is preferably from 1 to 15 hours.

The polyamine borate used in the present invention is a solid powder which is almost free from irritating odor peculiar to amine and is soluble in water or a lower alcohol such as methanol, and also it is preferably used as a curing agent of an epoxy resin.

As the curing agent of the epoxy resin in the present invention, polyamine borates such as ethylenediamine borate, diethylenetriamine borate, triethylenetetramine borate and tetraethylenepentamine borate; polyamideamine borates obtained from RACCAMIDE TD-984 and EPICLON B-053; and imidazole borates such as 2-ethyl-4-methylimidazole borate are used particularly preferably among the polyamine borates described above. These polyamine borates are used as an effective curing agent of an epoxy resin in the present invention even if they are crystalline or noncrystallinine, or mononuclear borates or polynuclear condensed borates.

The amount of various polyamine borates which can be used as the epoxy resin curing agent in the present invention can be decided based on the amount in which the amine-based compound used is usually used as the epoxy resin curing agent. In order to obtain sufficient heat resistance of the resulting cured article, the amount may drastically increase. The amount of the polyamine borate is preferably from 4 to 120 parts by mass, that is, 4 to 120 phr, based on 100 parts by mass of the epoxy resin. Specifically, when the polyamine borate is used, the amount is preferably from 5 to 50 phr, more preferably from 10 to 40 phr, and particularly preferably from 15 to 30 phr, based on the epoxy resin. When the polyamideamine borate is used, the amount is preferably from 10 to 120 phr, more preferably from 15 to 80 phr, and particularly preferably from 20 to 60 phr, based on the epoxy resin. When the 2-ethyl-4-methylimidazole borate is used, the amount is preferably from 4 to 35 phr, more preferably from 6 to 30 phr, and particularly preferably from 8 to 25 phr, based on the epoxy resin.

In view of an improvement in heat resistance, strength and other physical properties of the cured article of the epoxy resin, the boron content of the polyamine borate is preferably from 0.2 to 10 parts by mass based on 100 parts by mass of the epoxy resin.

In the epoxy resin composition of the present invention, an epoxy resin curing agent having a long pot life can be used in combination with the polyamine borate. As the epoxy resin curing agent, which can be used in combination with the polyamine borate, an epoxy resin curing agent used for forming laminate, which has a pot life at room temperature to the epoxy resin of 10 days or more, is preferably used. Such a pot life is a time required for a composition comprising an epoxy resin, an epoxy resin curing agent and a solvent to cause gelation (curing) by standing at room temperature. The pot life can be measured by touching the composition with a fingure. When the curing agent is capable of reacting with the epoxy resin, the measurement is conducted so that the amount of active hydrogen of the curing agent is 1 equivalent based on 1 equivalent of the epoxy resin. In case of a tertiary amine and an imidazole compound, the measurement is conducted so that the amount is 2 parts by mass based on 100 parts by mass of the epoxy resin.

As the other epoxy resin curing agent usable in the present invention, an epoxy resin curing agent having latent curability and a long pot life is used preferably. Specific examples thereof include a curing agent capable of reacting with the epoxy resin such as dicyandiamide, phenol novolak resin or metaphenylenediamine, a tertiary amine and an imidazole compound. The amount of the curing agent varies depending on the amount of an amine borate to be used in combination. In case of the curing agent capable of reacting with the epoxy resin, the amount of active hydrogen of the curing agent is preferably from 0.1 to 0.95 equivalents based on 1 equivalent of the epoxy resin. In case of the tertiary amine and the imidazole compound, the amount is preferably from 1 to 3 phr based on the epoxy resin.

When the other epoxy resin curing agent is used, regarding the amount of the polyamine borate, an active hydrogen equivalent of polyamine contained therein is preferably from 0.05 to 0.5 equivalents based on 1 equivalent of the epoxy resin. When the amount is within the above range, the resulting composition is excellent in heat resistance and storage stability, and also it is easy to perform the B-staging in the production of a laminate, and therefore it is preferable.

In the present invention, it is essential to use the polyamine borate as the curing agent of the epoxy resin. To the contrary, when the monoamine borate, which has been used as a curing accelerator of a conventional epoxy resin, such as dipropylamine borate, is added to the epoxy resin, followed by curing, curability is insufficient and the resulting cured article is insufficient in strength and heat resistance.

When polyamine as a curing agent as well as boric acid or an boric acid ester as a curing inhibitor are separately added to the epoxy resin, followed by curing, if the amount of boric acid is small, the cured article is inferior in heat resistance. On the other hand, if considerably large amount of boric acid is added, curability deteriorates and only a cured article having lowered strength is obtained.

The solvent of the epoxy resin composition, which can be used in the present invention, may be a solvent which can uniformly dissolve the epoxy resin and the polyamine borate, or a solvent which does not dissolve the polyamine borate but dissolves the epoxy resin. As the solvent which can dissolve the epoxy resin and the polyamine borate, a solvent containing a lower alcohol can be used in general. Examples thereof include solvent mixtures prepared by adding lower alcohols having about 1 to 6 carbon atoms such as methanol, ethanol and isopropanol to solvents such as acetone, methyl ethyl ketone, tetrahydrofuran, N,N-dimethylformamide, N-methyl pyrrolidone, N,N-dimethylacetamide, dimethyl sulfoxide and methylethyl cellosolve. For the purpose of obtaining an epoxy resin composition having excellent storage stability, a solvent, which does not dissolve the polyamine borate and dissolves the epoxy resin, is preferably used. Examples thereof include acetone, methyl ethyl ketone, tetrahydrofuran, N,N-dimethylformamide, N-methyl pyrrolidone, N,N-dimethylacetamide and methylethyl cellosolve. These solvents can be used alone or in combination of two or more.

In the method for producing an epoxy resin composition of the present invention, it is very important to perform a heat treatment in a solution state where the epoxy resin and the polyamine borate are uniformly dissolved in the solvent so as to obtain a uniform and transparent epoxy resin composition. The heat treatment in a solution state refers to that the heat treatment is carried out by heating in a closed system without removing the solvent substantially and without causing gelation of the solution. The heat treatment causes the reaction or interaction between the epoxy resin and the polyamine borate, and thus the polyamine borate is uniformly compatibilized in an epoxy resin solution in a molecular level. The composition obtained by desolvation of the resulting solution is free from aggregation of the polyamine borate and becomes uniform and transparent. When the heat treatment in a solution state is not carried out, the polyamine borate is precipitated upon desolvation and the resulting cured article becomes an opaque and brittle material.

The conditions of the heat treatment in a solution state vary depending on ease of the reaction or interaction between the polyamine borate and the epoxy resin. It is important to carry out the heat treatment within a range between a lower limit where the polyamine borate is not precipitated as a result of the following desolvation and an upper limit where the solution is not gelled. When the heat treatment is carried out excessively, the composition causes thickening or gelation and a nongel-like resin composition can not be obtained, and thus it is not preferably from a practical point of view.

The heat treatment temperature in a solution state is preferably from 25 to 100°C, more preferably from 30 to 90°C, and particularly preferably from 40 to 80°C, when an aliphatic polyamine borate and a polyamideamine borate are used as the curing agent. The heat treatment time varies depending on the heat treatment temperature, but is preferably from 0.1 to 40 hours, more preferably from 0.2 to 30 hours, and particularly preferably from 0.3 to 20 hours.

When an imidazole borate is used, the heat treatment temperature in a solution state is preferably from 30 to 150°C, more preferably from 40 to 130°C, and particularly preferably from 50 to 110°C. The heat treatment time varies depending on the heat treatment temperature, but is preferably from 0.3 to 50 hours, more preferably from 0.5 to 40 hours, and particularly preferably from 1 to 25 hours.

In the method for producing an epoxy resin composition having storage stability of the present invention, an epoxy resin composition excellent in storage stability can be obtained by dissolving no polyamine borate in an epoxy resin, and uniformly microdispersing the polyamine borate in an epoxy resin or epoxy resin solution prepared by diluting the epoxy resin with a solvent. Examples of the method of microdispersing the polyamine borate include (1) a method of adding a polyamine borate to an epoxy resin, followed by kneading using a mixer or a roll, (2) a method of adding a polyamine borate and a solvent to an epoxy resin, followed by grinding and mixing using a blender, and (3) a method of adding a polyamine borate, a solvent and glass beads to an epoxy resin, followed by mixing and dispersing using a shaker. According to these methods, a polyamine borate is microdispersed in the epoxy resin in a micron or smaller order to present as a latent curing agent which does not react with the epoxy resin at normal temperature. The resulting composition may be a uniform material which is free from aggregation and sedimentation of the polyamine borate.

A solvent-free epoxy resin composition can be produced by removing the solvent from the epoxy resin composition obtained in the present invention without causing the curing reaction. The desolvation temperature varies depending on the curing agent used, but is preferably low temperature in a dry state, that is, it is preferably 100°C or lower, more preferably from 80°C or lower, and particularly preferably from 60°C or lower.

The solution-like thermosetting epoxy resin composition produced by the above method can be employed not only as a heat-resistant coating material to substrates such as metal, ceramic and heat-resistant plastic, but also as a heat-resistant impregnant of glass fibers.

One of application examples of the solution-like thermosetting epoxy resin composition of the present invention includes the production of a heat-resistant laminate sheet, comprising forming an uncured coating film layer of this solution-like thermosetting epoxy resin composition on the surface of a heat-resistant substrate sheet, laying another heat-resistant substrate sheet on the uncured coating film layer, and curing the uncured coating film layer after thermal contact bonding of both heat-resistant substrate sheets.

Examples of the heat-resistant substrate sheet include sheets made of heat-resistant materials selected from inorganic materials such as copper, aluminum, titanium and ceramic; organic materials such as heat-resistant polyester, polyamide and polyimide; and organic and inorganic composite materials such as glass fiber-reinforced polyester and glass fiber-reinforced epoxy resin.

For example, a heat-resistant substrate is coated or impregnated with the epoxy resin composition, followed by drying to obtain a prepreg. A copper-cladded laminate can be produced by laying this prepreg and a copper foil one upon another, followed by compressing with heating.

Also a copper-cladded laminate can be produced by directly coating the epoxy resin composition to a copper foil, drying the epoxy resin composition and laying the coated copper foil and an epoxy resin glass cloth plate one upon another, followed by compressing with heating.

The copper-cladded laminate thus obtained is excellent in heat resistance and resistance to moisture and soldering and is therefore preferably used as electronic components.

The powdered thermosetting epoxy resin in the present invention can be produced by uniformly dissolving an epoxy resin and a polyamine borate in a solvent containing a lower alcohol, subjecting the solution to a heat treatment, removing the solvent, and grinding the resulting solid thermosetting epoxy resin composition.

The solvent in the solution-like thermosetting epoxy resin composition can be removed by a conventional method using a hot air dryer, a freeze dryer, a vacuum dryer or the like. The solvent is preferably removed by heating the solution-like thermosetting epoxy resin composition to the temperature within a range from 25°C to 120°C in an atmospheric air under a heating gas flow or vacuum pressure. Preferable solvent removing temperature varies depending on the kind of the solvent and the kind of the polyamine borate. For example, it is within a range from 30°C to 100°C. Grinding can be carried out by a conventionally known method. It is preferred that the product is ground into powders having an average particle size of 300 µm or less and the resulting powders are further dried at the temperature within a range from 30 to 100°C under vacuum.

The powdered thermosetting epoxy resin composition produced by the above method is compression-molded and is optionally cured by subjecting to a heat treatment to obtain a heat-resistant cured molded article. In that case, the molding temperature varies depending on the epoxy resin and the polyamine borate used and is not specifically limited, but can be usually from 90°C to 200°C.

The thermosetting epoxy resin composition of the present invention can provide a cured article having a glass transition temperature which is 100°C to 230°C higher than, or further more higher than, that of a cured article made of an epoxy resin using only a conventional amine-based curing agent.

The thermosetting epoxy resin composition of the present invention can impart not only a glass transition temperature which is higher than that of a cured article made of an epoxy resin using only a conventional amine-based curing agent, but also excellent mechanical properties such as elastic modulus and strength, heat characteristics such as low linear thermal expansion coefficient and high elastic modulus at high temperature, and excellent flame retardancy to the cured article.

Furthermore, the solution-like and powdered thermosetting epoxy resin compositions excellent in storage stability of the present invention provides a cured article having high glass transition temperature and has excellent utility of the product, and also enables long-term storage of the product.

The thermosetting epoxy resin composition of the present invention has excellent characteristics described above and can be preferably used in wide fields, for example, electric and electronic members, copper-cladded laminates useful as circuit wiring board, conventional molding materials, coating materials, adhesives and the like.

### EXAMPLES

The present invention will now be described in detail by way of synthesis examples and examples.

In the following synthesis examples, a nuclear magnetic resonance spectrum (NMR) was measured using LAMBDA 300 manufactured by JEOL Ltd. ¹¹B-NMR spectrum was measured using a boric acid peak in heavy water as a standard.

Fourier transform infrared absorption spectrum (FT-IR) was measured within a range from 4000 to 400 cm⁻¹ using FT/IR-550 manufactured by JASCO Corporation.

Powder X-ray diffraction was measured using an X-ray diffractometer RINT ULTIMA⁺ manufactured by Rigaku Corporation.

Mass spectrometry was carried out by a EI/MS measuring method in which a sample is directly introduced, using mass spectrometer GCMS9100-MK manufactured by Shimadzu Corporation.

After measuring ICP using OPTIMA 3300DV manufactured by Perkin Elmer Co., the boron content was determined by a calibration curve made previously using boric acid.

The amine content was determined by an internal standard method of ¹H-NMR. That is, a fixed amount of benzene or chloroform as an internal standard was added to a sample, and the amine content was determined by an area ratio of a peak of benzene or chloroform to a specific peak of amine of a fixed amount of amine borate.

In synthesis examples of the present invention, the following reagents were used.

### (1) Amine-based compounds

Ethylenediamine (EDA): manufactured by Wako Pure Chemicals Industries, Ltd., analytical grade reagent
Diethylenetriamine (DETA): manufactured by Wako Pure Chemicals Industries, Ltd., analytical grade reagent
Triethylenetetramine (TETA): manufactured by Wako Pure Chemicals Industries, Ltd., analytical grade reagent
Tetraethylenepentamine (TEPA): manufactured by Wako Pure Chemicals Industries, Ltd., analytical grade reagent
Polyamideamine EPICLON B-053: manufactured by DAINIPPON INK AND CHEMICALS, INCORPOREATED, active hydrogen equivalent: 77 g/eq
Polyamideamine RACCAMIDE TD-984: manufactured by DAINIPPON INK AND CHEMICALS, INCORPOREATED, active hydrogen equivalent: 97 g/eq
2-ethyl-4-methylimidazole (2E4MZ): manufactured by Wako Pure Chemicals Industries, Ltd., analytical grade reagent

### (2) Boric acid: manufactured by Wako Pure Chemicals Industries, Ltd., analytical grade reagent

### (3) Solvents

N,N-dimethylformamide(DMF): manufactured by Wako Pure Chemicals Industries, Ltd., analytical grade reagent
Methyl ethyl ketone(MEK):manufactured by Wako Pure Chemicals Industries, Ltd., analytical grade reagent
Acetone: manufactured by Wako Pure Chemicals Industries, Ltd., first class grade reagent
Tetrahydrofuran (THF): manufactured by Wako Pure Chemicals Industries, Ltd., analytical grade reagent
Hexane: manufactured by Wako Pure Chemicals Industries, Ltd., first class grade reagent
Methanol: manufactured by Wako Pure Chemicals Industries, Ltd., analytical grade reagent

### (4) Curing agents

Dicyandiamide (DICY): manufactured by Wako Pure Chemicals Industries, Ltd., analytical grade reagent
Phenol novolak resin TD2090-60M: manufactured by DAINIPPON INK AND CHEMICALS, INCORPOREATED, active hydrogen equivalent: 105 g/eq, solid content: 60%
Metaphenylenediamine (m-PDA): manufactured by Wako Pure Chemicals Industries, Ltd., analytical grade reagent (Synthesis Example 1) [Synthesis of ethylenediamine condensed borate]
While stirring a solution prepared by dissolving 10 g (0.162 mol) of boric acid in 70 g of DMF, 4.86 g (0.081 mol) of ethylenediamine (EDA) was added dropwise. As a result, a white precipitate was immediately produced. After stirring at room temperature for 2 hours, the precipitate was collected by suction filtration. Subsequently, the resulting precipitate was washed in turn with DMF and acetone and then vacuum-dried at 50°C for 2 hours to obtain 6.34 g of a white powder 1a. DMF was distilled off from the filtrate by an evaporator and the resulting white solid was washed with acetone. The white solid was vacuum-dried at 50°C for 2 hours to obtain 4.58 g of a white powder which is the same as the white powder 1a. Yield of the reaction product was 73.5% based on raw materials. The analytical results are shown in Table 1, Table 2 and Table 3.

### (Synthesis Example 2) [Synthesis of ethylenediamine condensed borate]

While stirring a solution prepared by dissolving 40 g (0.647 mol) of boric acid in 250 g of DMF, 9.72 g (0.162 mol) of ethylenediamine (EDA) was added dropwise. As a result, a white precipitate was immediately produced. After stirring at room temperature for 4 hours, the precipitate was collected by suction filtration. Subsequently, the resulting precipitate was washed in turn with DMF and acetone and then vacuum-dried at 50°C for 15 hours to obtain 35.4 g of a white powder 2a as the reaction product in yield of 71.2% based on raw materials. NMR spectrum was the same as that of the white powder 1a. The analytical results are shown in Table 2 and Table 3.

### (Synthesis Example 3) [Synthesis of ethylenediamine condensed borate]

While stirring a solution prepared by dissolving 30 g (0.485 mol) of boric acid in 250 g of DMF, 29.2 g (0.485 mol) of ethylenediamine (EDA) was added dropwise. As a result, a white precipitate was immediately produced. After stirring at room temperature for 15 hours, the precipitate was collected by suction filtration. Subsequently, the resulting precipitate was washed in turn with DMF and acetone and then vacuum-dried at 50°C for 15 hours to obtain 28.1 g of a white powder 3a as the reaction product in yield of 47.4% based on raw materials. NMR spectrum was the same as that of the white powder 1a. The analytical results are shown in Table 2 and Table 3.

### (Synthesis Example 4) [Synthesis of ethylenediamine condensed borate]

While stirring a solution prepared by dissolving 30 g (0.485 mol) of boric acid in 120 g of distilled water (H₂O), 14.6 g (0.243 mol) of ethylenediamine (EDA) was added dropwise. The reaction was carried out at room temperature for 2 hours. Water was distilled off by an evaporator, followed by vacuum drying at 60°C for 5 hours to obtain 34.2 g of a white powder 4a as the reaction product in yield of 77% based on raw materials. NMR spectrum was the same as that of the white powder 1a. The analytical results are shown in Table 2 and Table 3.

### (Synthesis Example 5) [Synthesis of diethylenetriamine condensed borate]

While stirring a solution prepared by dissolving 60 g (0.971 mol) of boric acid in 500 g of DMF, 33.4 g (0.324 mol) of diethylenetriamine (DETA) was added dropwise. As a result, a white precipitate was immediately produced. After stirring at room temperature for 5 hours, the precipitate was collected by suction filtration. Subsequently, the resulting precipitate was washed in turn with DMF, acetone and hexane and then vacuum-dried at 50°C for 15 hours to obtain 64.8 g of a white powder 1b as the reaction product in yield of 69.4% based on raw materials. The analytical results are shown in Table 1, Table 2 and Table 3.

### (Synthesis Example 6) [Synthesis of diethylenetriamine condensed borate]

While stirring a solution prepared by dissolving 60 g (0.971 mol) of boric acid in 500 g of DMF, 11.1 g (0.108 mol) of diethylenetriamine DETA was added dropwise. As a result, a white precipitate was immediately produced. After stirring at room temperature for 13 hours, the precipitate was collected by suction filtration. Subsequently, the resulting precipitate was washed in turn with DMF and acetone and then vacuum-dried at 50°C for 12 hours to obtain 48.3 g of a white powder 2b as the reaction product in yield of 67.9% based on raw materials. NMR spectrum was the same as that of the white powder 1b. The analytical results are shown in Table 2 and Table 3.

### (Synthesis Example 7) [Synthesis of diethylenetriamine condensed borate]

While stirring a solution prepared by dissolving 33.4 g (0.324 mol) of diethylenetriamine (DETA) in 250 g of DMF, a solution prepared by dissolving 30 g (0.485 mol) of boric acid in 150 g of DMF was added dropwise. As a result, a white precipitate was immediately produced. After stirring at room temperature for 14 hours, the precipitate was collected by suction filtration. Subsequently, the resulting precipitate was washed in turn with DMF and acetone and then vacuum-dried at 50°C for 5 hours to obtain 28.5 g of a white powder 3b as the reaction product in yield of 45% based on raw materials. NMR spectrum was the same as that of the white powder 1b. The analytical results are shown in Table 2 and Table 3.

### (Synthesis Example 8) [Synthesis of diethylenetriamine condensed borate]

While stirring a solution prepared by dissolving 20 g (0.324 mol) of boric acid in 160 g of distilled water (H₂O), 11.2 g (0.108 mol) of diethylenetriamine (DETA) was added. The reaction was carried out at room temperature for 12 hours. Water was distilled off by an evaporator, followed by vacuum drying at 60°C for 17 hours to obtain 25 g of a white powder 4b as the reaction product in yield of 80% based on raw materials. NMR spectrum was the same as that of the white powder 1b. The analytical results are shown in Table 2 and Table 3.

### (Synthesis Example 9) [Synthesis of diethylenetriamine condensed borate]

While stirring a solution prepared by dissolving 20 g (0.324 mol) of boric acid in 200 g of distilled water (H₂O), 22.4 g (0.216 mol) of diethylenetriamine (DETA) was added dropwise. The reaction was carried out at room temperature for 13 hours. Water was distilled off by an evaporator, followed by washing with acetone. The resulting white powder was vacuum-dried at 50°C for 4 hours to obtain 26.8 g of a white powder 5b as the reaction product in yield of 63.2% based on raw materials. NMR and FT-IR spectra were the same as those of the white powder 4b. The other analytical results are shown in Table 3.

### (Synthesis Example 10) [Synthesis of triethylenetetramine borate]

While stirring a solution prepared by dissolving 60 g (0.971 mol) of boric acid in 600 g of DMF, 35.5 g (0.243 mol) of triethylenetetramine (TETA) was added dropwise. As a result, a white precipitate was immediately produced. After stirring at room temperature for 12 hours, the precipitate was collected by suction filtration. Subsequently, the resulting precipitate was washed in turn with DMF, acetone and hexane and then vacuum-dried at 50°C for 15 hours to obtain 69.9 g of a white powder 1c as the reaction product in yield of 73.2% based on raw materials. The analytical results are shown in Table 1, Table 2 and Table 3.

### (Synthesis Example 11) [Synthesis of triethylenetetramine borate]

While stirring a solution prepared by dissolving 20 g (0.324 mol) of boric acid in 160 g of distilled water H₂O, 11.85 g (0.081 mol) of triethylenetetramine (TETA) was added. The reaction was carried out at room temperature for 15 hours. Water was distilled off by an evaporator, followed by vacuum drying at 60°C for 5 hours to obtain 26.9 g of a white powder 2c as the reaction product in yield of 84.3% based on raw materials. NMR and FT-IR spectra were the same as those of the white powder 1c. The other analytical results are shown in Table 3.

### (Synthesis Example 12) [Synthesis of tetraethylenepentamine borate]

While stirring a solution prepared by dissolving 60 g (0.971 mol) of boric acid in 600 g of DMF, 36.8 g (0.194 mol) of tetraethylenepentamine TEPA was added dropwise. As a result, a white precipitate was immediately produced. After stirring at room temperature for 13 hours, the precipitate was collected by suction filtration. Subsequently, the resulting precipitate was washed in turn with DMF, acetone and hexane and then vacuum-dried at 50°C for 9 hours to obtain 70.7 g of a white powder 1d as the reaction product in yield of 73% based on raw materials. The analytical results are shown in Table 1, Table 2 and Table 3.

### (Synthesis Example 13) [Synthesis of tetraethylenepentamine borate]

While stirring a solution prepared by dissolving 60 g (0.971 mol) of boric acid in 500 g of DMF, 18.4 g (0.0972 mol) of tetraethylenepentamine (TEPA) was added dropwise. As a result, a white precipitate was immediately produced. After stirring at room temperature for 17 hours, the precipitate was collected by suction filtration. Subsequently, the resulting precipitate was washed in turn with DMF and acetone and then vacuum-dried at 70°C for 5 hours to obtain 60 g of a white powder (2d) as the reaction product in yield of 77% based on raw materials. NMR was measured. As a result, the same spectrum as that of the white powder 1d was obtained. The other analytical results are shown in Table 3.

### (Synthesis Example 14) [Synthesis of tetraethylenepentamine borate]

While stirring a solution prepared by dissolving 20 g (0.324 mol) of boric acid in 160 g of distilled water (H₂O), 12.27 g (0.065 mol) of tetraethylenepentamine (TEPA) was added. The reaction was carried out at room temperature for 15 hours. Water was distilled off by an evaporator, followed by vacuum drying at 60°C for 2 hours to obtain 28 g of a white powder 3d as the reaction product in yield of 86.6% based on raw materials. NMR and FT-IR spectra were the same as those of the white powder 1d. The other analytical results are shown in Table 3.

### (Synthesis Example 15) [Synthesis of EPICLON B-053 condensed borate]

While stirring a solution prepared by suspending 30 g (0.485 mol) of boric acid in 200 g of MEK, 37.4 g of EPICLON B-053 was added dropwise. After stirring at room temperature for 24 hours, the white precipitate was collected by suction filtration. Subsequently, the resulting precipitate was washed in turn with DMF, acetone and hexane and then vacuum-dried at 50°C for 15 hours to obtain 20.9 g of a yellow-ocherous powder 1e as the reaction product in yield of 31% based on raw materials. The analytical results are shown in Table 2 and Table 3.

### (Synthesis Example 16) [Synthesis of EPICLON B-053 borate]

While stirring a solution prepared by dissolving 45 g (0.728 mol) of boric acid in 500 g of DMF, 112.1 g of EPICLON B-053 was added dropwise. As a result, a white precipitate was immediately produced. After stirring at room temperature for 7 hours, the precipitate was collected by suction filtration. Subsequently, the resulting precipitate was washed in turn with acetone and hexane and then vacuum-dried at 50°C for 15 hours to obtain 50.1 g of a pale yellow-ocherous powder 2e as the reaction product in yield of 31.8% based on raw materials. The analytical results are shown in Table 2 and Table 3.

### (Synthesis Example 17) [Synthesis of TD-984 borate]

While stirring a solution prepared by dissolving 30 g (0.485 mol) of boric acid in 500 g of DMF, 94.1 g of RACCAMIDE TD-984 was poured into the solution. As a result, a precipitate was immediately produced. After stirring at room temperature for 13 hours, the precipitate was collected by suction filtration. Subsequently, the resulting precipitate was washed in turn with DMF and acetone and then vacuum-dried at 50°C for 4 hours to obtain 46 g of a pale yellow-ocherous powder 1f as the reaction product in yield of 37.1% based on raw materials. The analytical results are shown in Table 2 and Table 3.

### (Synthesis Example 18) [Synthesis of 2-ethyl-4-methylimidazole condensed borate]

While stirring a solution prepared by dissolving 20 g (0.324 mol) of boric acid in 80 g of DMF, a solution of 17.8 g (0.162 mol) of 2-ethyl-4-methylimidazole (2E4MZ) in 40 g of DMF was added dropwise. As a result, a white precipitate was immediately produced. After stirring at room temperature for 13 hours, the precipitate was collected by suction filtration. Subsequently, the resulting precipitate was washed in turn with DMF and acetone and then vacuum-dried at 50°C for 4 hours to obtain 12.9 g of a white powder 1k as the reaction product in yield of 34.1% based on raw materials. The analytical results are shown in Table 1, Table 2 and Table 3. In mass spectrometry, a peak having a mass number of 110 corresponding to 2-ethyl-4-methylimidazole was observed.

### (Synthesis Example 19) [Synthesis of dipropylamine condensed borate]

While stirring a solution prepared by dissolving 15.3 g (0.25 mol) of boric acid in 80 g of DMF, 25 g (0.25 mol) of dipropylamine was added dropwise. The reaction was carried out at room temperature for 19 hours. DMF was distilled off by an evaporator and the resulting solid was repeatedly washed three times with acetone. The solid was vacuum-dried at 70°C for 3 hours to obtain 15 g of a white powder 11 as the reaction product in yield of 37.5% based on raw materials. The analytical results are shown in Table 3.

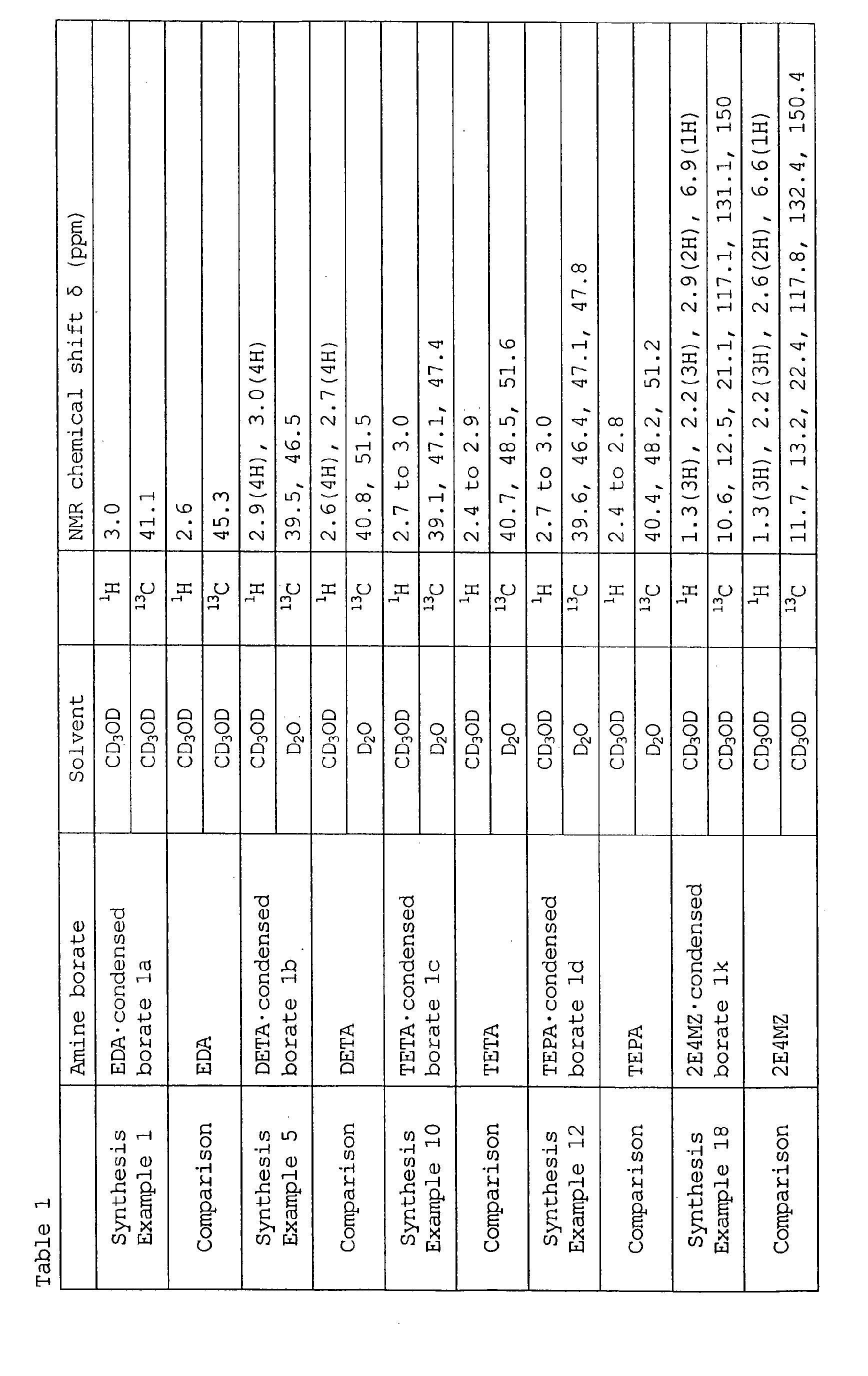

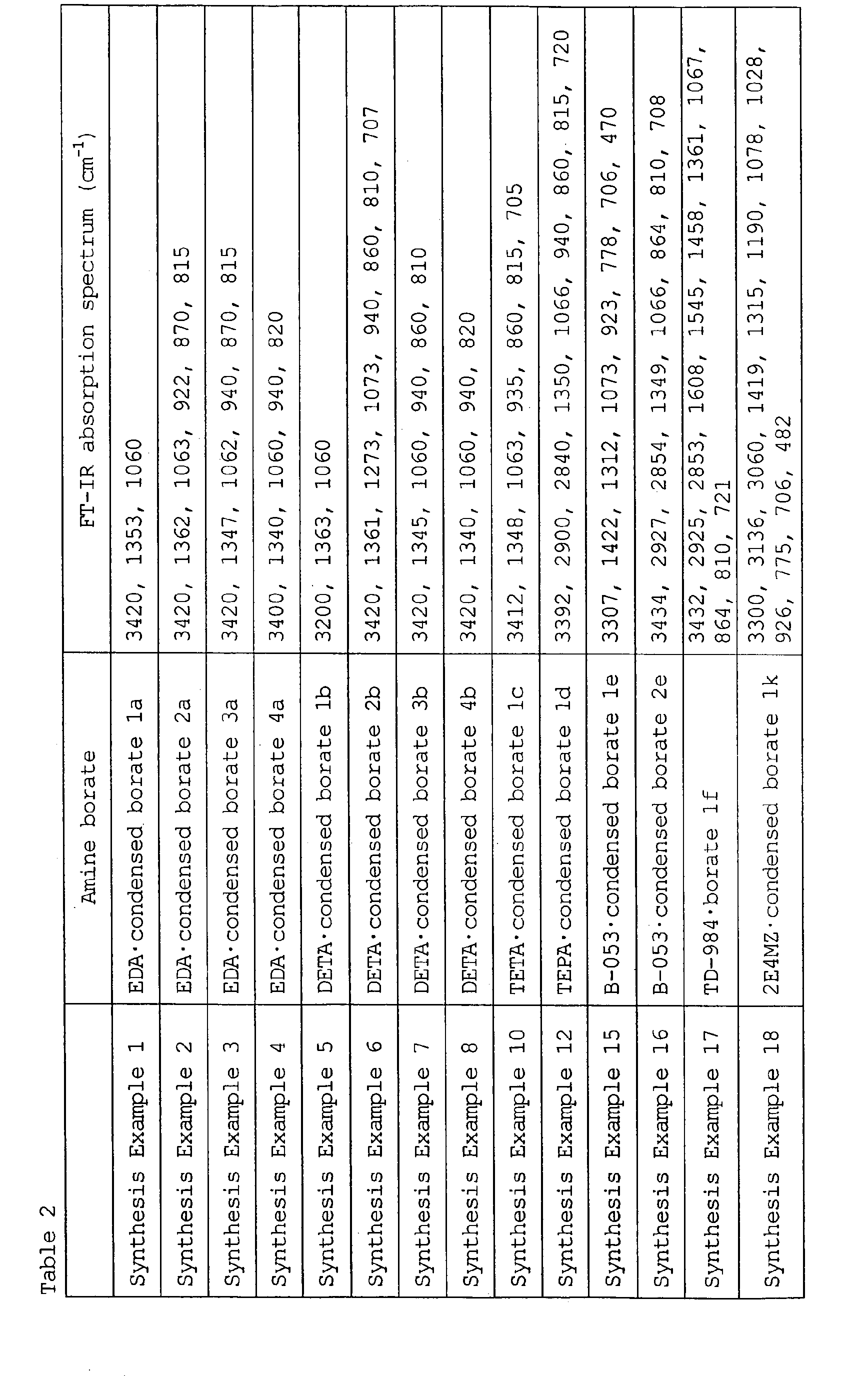

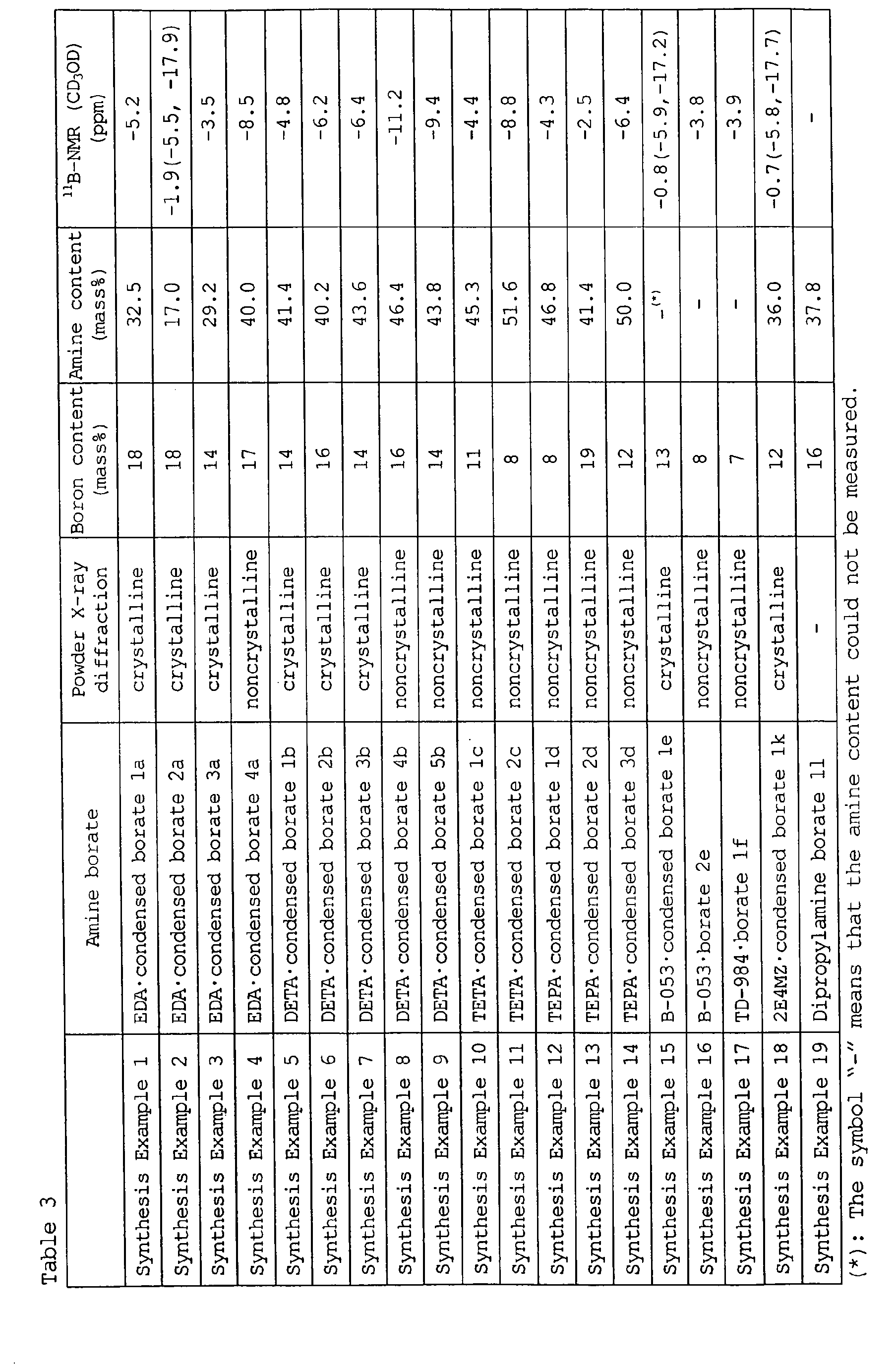

In the following examples and comparative examples, a parallel light transmittance of a film having a thickness of 300 µm was measured using NDH-300A manufactured by Nippon Denshoku Industries Co., Ltd. A glass transition temperature and a storage elastic modulus (E') were measured at a measuring frequency of 1 Hz and a temperature raising rate of 2°C/min using a solid dynamic viscoelasticity measuring apparatus (DMA-200, manufactured by Seiko Electronic Industry Co., Ltd.). The glass transition temperature (Tg) determined was a tan δ peak temperature (tan δ max). Water absorption was determined by measuring an initial weight and an increase in weight after standing in an atmosphere at humidity of 100% for 70 hours and calculating a ratio of them.

### (Example 1 and Comparative Example 1)

While stirring a solution prepared by dissolving 24.4 g of an ethylenediamine condensed borate 1a in 80 g of methanol, MEK was added dropwise. To the resulting transparent solution, 100 g of a bisphenol A type epoxy resin EPICLON 850 (manufactured by DAINIPPON INK AND CHEMICALS, INCORPOREATED, epoxy equivalent: 190 g/eq) was added, followed by mixing with stirring and a heat treatment in a solution state at 50°C for 1.5 hours to obtain an epoxy resin composition solution. Subsequently, the solution was applied on a clean aluminum foil, followed by solvent casting for 12 hours, drying at 50°C, 60°C, 70°C, 80°C and 90°C for each one hour and further a heat treatment at 150°C and 180°C for each 2 hours to obtain a cured article of the epoxy resin composition. The resulting cured article was burned in a nitrogen atmosphere at 1000°C for 2 hours to obtain 11.5 g of a black ash.

The cured article was excellent in transparency and a light transmittance in a visible light region was 93% (it was measured in terms of a thickness of 100 µm). The cured article was free from cracking, wrinkles and bubbles and showed good surface state. The evaluation results of the resulting cured article are shown in Table 4.

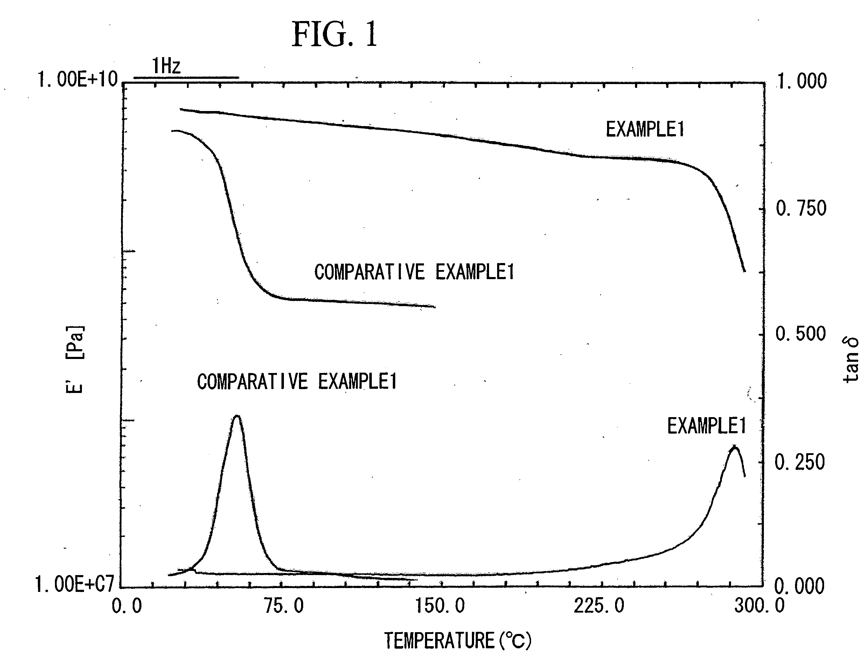

Using a cured film having a thickness of 300 µm obtained in Example 1, dynamic viscoelasticity was measured (frequency: 1 Hz). A relation between the storage elastic modulus (E'), the tan δ and the temperature is shown in Fig. 1. The axis of ordinate of Fig. 1 indicates the storage elastic modulus (E') and the axis of abscissas indicates the temperature (°C). In Fig. 1, the results of Comparative Example 1, which is a cured article having the same epoxy resin composition except for using ethylenediamine in place of ethylenediamine condensed borate, are also shown. The peak temperature (Tg) of tan δ was 54.3°C in Comparative Example 1, whereas, the peak temperature of the epoxy resin cured article was 286.5°C in Example 1. It is apparent that heat resistance of the epoxy resin cured article using polyamine borate as a curing agent is remarkably improved.

### (Example 2)

In Example 2, an epoxy resin composition and a cured article thereof were produced in the same manner as in Example 1, except that a low-bromo bisphenol A type epoxy resin EPICLON EXA-9101 (manufactured by DAINIPPON INK AND CHEMICALS, INCORPOREATED, epoxy equivalent: 368 g/eq, solid content: 80.5%) was used. The evaluation results of the resulting cured article are shown in Table 4, similar to Example 1.

**Table 4**

| | | Example 1 | Example 2 | Comparative Example 1 |
|---|---|---|---|---|
| Epoxy resin composition | Epoxy resin D | 850 | EXA-9101 | 850 |
| | Weight (g) | 100 | 124.2 | 100 |
| | Epoxy equivalent (g/eq) | 190 | 368 | 190 |
| | Amine borate | 1a | 1a | EDA |
| | Weight (g) | 24.4 | 19 | 7.9 |
| | Amine content (g) | 7.9 | 6.2 | - |
| | Epoxy equivalent ratio (%) | 100 | 152 | 100 |
| | Boron content based on D (% by mass) | 4.4 | 3.4 | - |
| | Solvent (g) | MeOH 80 | MeOH 80 | MEK 160 |
| | | MEK 80 | MEK 60 | |
| Heat treatment in solution state | | 50°C, 1.5 hrs | 50°C, 1.5 hrs | - |
| Cured article | Light transmittance (%) | 93 | 88 | 92 |
| | Tg (°C) | 286.5 | 258.3 | 54.3 |

### (Example 3 and Comparative Examples 2 to 3)

In Example 3, a transparent solution of an epoxy resin and a polyamine borate was prepared in the same manner as in Example 1, except that a tetraethylenepentamine condensed borate 1d was used, and then subjected to a heat treatment in a solution state at 80°C for 30 minutes. Using the resulting epoxy resin composition solution, a cured article of the epoxy resin composition solution was produced in the same manner as in Example 1. The dynamic viscoelasticity of the resulting cured article was measured. As a result, Tg was 289°C.

To the contrary, in the cured article of Comparative Example 2 in which a dipropylamine condensed borate of monoamine borate was used as a curing accelerator and dicyandiamide (DICY) was used as an amine curing agent, Tg was 144°C at most and an improvement in heat resistance was not recognized. With respect to the cured article obtained by using boric acid and a TEPA curing agent in place of the polyamine borate and mixing them with the epoxy resin, Tg was 143°C at most and an improvement in heat resistance was not recognized in case of Comparative Example 3 in which a small amount of boric acid was added. When the amount of boric acid was increased so as to correspond to Example 3, a subpeak of tan δ was observed at 107°C and therefore a partial resin cured article showed low Tg. These results are summarized in Table 5.

**Table 5**

| | | Example 3 | Comparative Example 2 | Comparative Example 3 |
|---|---|---|---|---|
| Epoxy resin composition | Epoxy resin D | 850 | 850 | 850 |
| | Weight (g) | 100 | 100 | 100 |
| | Epoxy equivalent (g/eq) | 190 | 190 | 190 |
| | Amine borate/boric acid | 1d | 11 | Boric acid |
| | Weight (g) | 18.7 | 3 | 2 |
| | Amine content (g) | 8.8 | 1.1 | - |
| | Epoxy equivalent ratio (%) | 61.6 | 5.6 | - |
| | Boron content based on D (% by mass) | 1.5 | 0.48 | 0.35 |
| | Curing agent | - | DICY | TEPA |
| | Weight (g) | - | 5.6 | 8.6 |
| | Epoxy equivalent ratio (%) | - | 50 | 60 |
| | Solvent (g) | MeOH 80 | MeOH 60 | MeOH 80 |
| | | MEK 80 | DMF 60 | MEK 80 |
| Heat treatment in solution state | | 80°C, 30 min | 50°C, 2 days | 50°C, 3 hrs |
| Cured article | Light transmittance (%) | 92 | 90 | 92 |
| | Tg (°C) | 289 | 144 | 143 |

### (Examples 4 to 6)

A transparent solution of an epoxy resin and a polyamine borate was prepared in the same manner as in Example 1, except that a triethylenetetramine condensed borate 1c was used in Example 4, EPICLON 1121N-80M and a triethylenetetramine condensed borate 1c were used in Example 5, and EPICLON 1121N-80M and a tetraethylenepentamine condensed borate 1d were used in Example 6, and then subjected to a heat treatment in a solution state under the conditions shown in Table 6. Using the resulting epoxy resin composition solution, a cured article thereof was produced in the same manner as in Example 1. All of the resulting cured articles showed excellent transparency and high glass transition temperature (Tg). Regardless of high Tg, the resulting cured articles showed comparatively low water absorption. The evaluation results of the resulting cured articles are shown in Table 6.

**Table 6**

| | | Example 4 | Example 5 | Example 6 |
|---|---|---|---|---|
| | Epoxy resin D | 850 | 1121N | 1121N |
| | Weight (g) | 100 | 125 | 125 |
| | Epoxy equivalent (g/eq) | 190 | 493 | 493 |
| Epoxy resin composition | Amine borate | 1c | 1c | 1d |
| | Weight (g) | 17.2 | 13.3 | 14.5 |
| | Amine content (g) | 7.8 | 6.0 | 6.8 |
| | Epoxy equivalent ratio (%) | 61.8 | 124 | 124 |
| | Boron content based on D (% by mass) | 1.9 | 1.5 | 1.2 |
| | Solvent (g) | MeOH 80 | MeOH 70 | MeOH 70 |
| | | MEK 80 | MEK 70 | MEK 70 |
| Heat treatment in solution state | | 80°C, 30 min | 80°C, 20 min | 80°C, 20 min |
| Cured article | Light transmittance (%) | 94 | 86 | 91 |
| | Tg (°C) | 287.6 | 265.3 | 267.6 |
| | Water absorption | 3.1 | 3 | 2.8 |

### (Examples 7 to 9)

A transparent solution of an epoxy resin and a polyamine borate was prepared in the same manner as in Example 1, except that a B-053·condensed borate 1e was used in Example 7, a B-053·borate 2e was used in Example 8, and a 2-ethyl-4-methylimidazole condensed borate 1k was used in Example 9, and then subjected to a heat treatment in a solution state under the conditions shown in Table 7. Using the resulting epoxy resin composition solution, a cured article thereof was produced in the same manner as in Example 1. Dynamic viscoelasticity of the resulting cured articles was measured. As a result, Tg of the cured articles of the epoxy resin compositions obtained in Examples 7 to 9 was remarkably improved. The evaluation results of the resulting cured articles are shown in Table 7.

**Table 7**

| | | Example 7 | Example 8 | Example 9 |
|---|---|---|---|---|
| Epoxy resin composition Amine | Epoxy resin D | 850 | 850 | 850 |
| | Weight (g) | 100 | 100 | 100 |
| | Epoxy equivalent (g/eq) | 190 | 190 | 190 |
| | Amine borate | 1e | 2e | 1k |
| | Weight (g) | 37 | 45.4 | 16.8 |
| | content (g) | - | - | 6.1 |
| | Mixing ratio (phr) | 37 | 45.4 | 16.8 |
| | Boron content based on D (% by mass) | 4.8 | 3.6 | 2.0 |
| | Solvent (g) | MeOH 120 | MeOH 80 | MeOH 80 |
| | | MEK 80 | MEK 80 | MEK 80 |
| Heat treatment in solution state | | 80°C, 50 min | 80°C, 1 hr | 80°C, 6 hrs |
| Storage stability | | -(*) | - | 60 days/50°C |
| Cured article | Light transmittance (%) | 84 | 90 | 88 |
| | Tg (°C) | 261 | 266.8 | 285.4 |

| | | | | |
|---|---|---|---|---|
| (*): The symbol "-" in storage stability of the table means that the measurement was not carried out. | | | | |

### (Examples 10 and 11)

In Example 10, 100 g of EPICLON 850, 24 g of a diethylenetriamine condensed borate 1b and 47 g of a diluent MEK were mixed and charged in a vessel, together with glass beads, and then a polyamine borate was uniformly microdispersed in an epoxy resin by vibrating using a shaker for 15 hours. The resulting composition was allowed to stand at 50°C for 2 or more months. As a result, thickening of the solution did not occur and aggregation and sedimentation of the amine borate did not occur, and thus the composition showed excellent storage stability. In the same manner as in Example 1, except that this composition was subjected to a heat treatment at 180°C for 5 hours, a cured article of an epoxy resin composition was produced. The resulting cured article showed very high Tg.

In Example 11, an epoxy resin composition excellent in storage stability and a cured article thereof were produced in the same manner as in Example 10, except that EPICLON EXA-9101 and a tetraethylenepentamine borate 1d were used. The evaluation results are shown in Table 8.

**Table 8**

| | | Example 10 | Example 11 |
|---|---|---|---|
| Epoxy resin composition excellent in storage stability | Epoxy resin D | 850 | EXA9101 |
| | Weight (g) | 100 | 125 |
| | Epoxy equivalent (g/eq) | 190 | 368 |
| | Polyamine borate | 1b | 1d |
| | Weight (g) | 24 | 14.7 |
| | Amine content (g) | 9.9 | 6.9 |
| | Epoxy equivalent ratio (%) | 90 | 94 |
| | Boron content based on D (% by mass) | 3.4 | 1.2 |
| | Solvent (g) | MEK 47 | MEK 23 |
| Storage stability | | 60 days/50°C | 60 days/50°C |
| Tg (°C) of cured article | | 271.9 | 291.3 |

### (Example 12)

While stirring a solution prepared by dissolving 21.3 g of a tetraethylenepentamine condensed borate 1d in 80 g of methanol, 80 g of MEK was added dropwise. To the resulting transparent solution, 100 g of EPICLON 850 was added, followed by mixing with stirring and a heat treatment in a solution state at 80°C for 50 minutes to obtain an epoxy resin composition solution. Subsequently, the solution was spread over a tray, solvent-casted in an atmospheric air at room temperature for 12 hours, dried in a hot air dryer at 50°C and 60°C for each one hour and then vacuum-dried at 70°C for one hour. The resulting sample was frozen with liquid nitrogen and ground into powders having a particle size of 300 µm or less. Subsequently, the resulting powder was dried under vacuum at 60°C for 2 hours to obtain a powdered thermosetting epoxy resin composition.

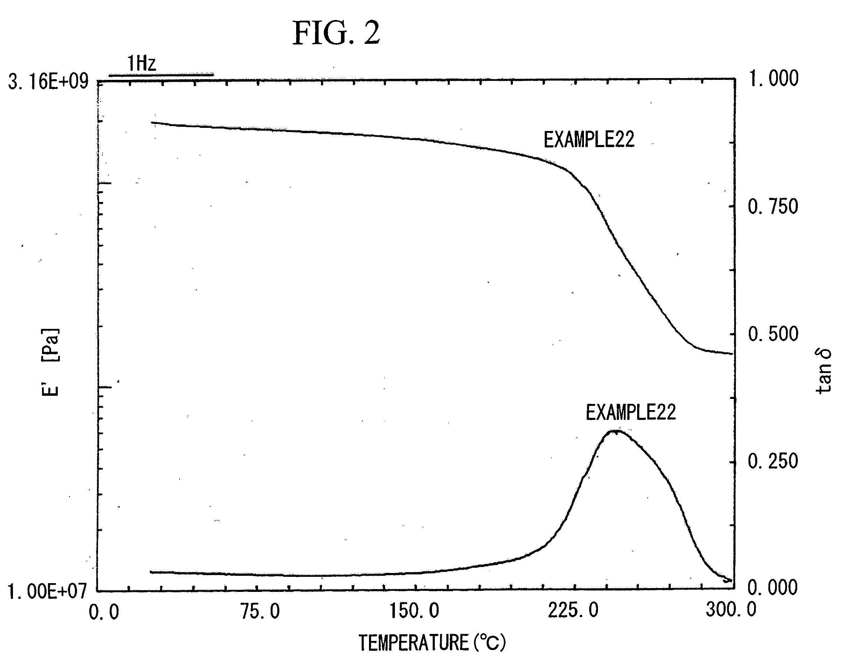

The resulting powdered thermosetting epoxy resin composition was hot pressed at 150°C to obtain a plate-like epoxy resin molded piece having a thickness of 1 mm. The resulting molded piece was subjected to a heat treatment at 150°C for 2 hours, then at 180°C for 4 hours. The resulting cured article was excellent in heat resistance and a glass transition temperature as measured by dynamic viscoelasticity was 243°C (Fig. 2). The cured article was also excellent in transparency and light transmittance in a visible light region of the above molded piece was 80%. The powdered thermosetting epoxy resin composition was allowed to stand at normal temperature for 3 months and physical properties of the hot pressed cured article obtained therefrom were evaluated. As a result, the same results were obtained and it was confirmed that the cured article is excellent in storage stability.

### (Example 13 and Comparative Example 7)

While stirring a solution prepared by dissolving 5 g of a tetraethylenepentamine borate 1d in 60 g of methanol, a solution of 2.8 g of dicyandiamide (DICY), 0.4 g of 2-ethyl-4-methylimidazole (2E4MZ) and 80 g of DMF was added dropwise. To the resulting transparent solution, 125 g of a low-bromo bisphenol A type epoxy resin EPICLON EXA-9101 was added, followed by mixing with stirring and a heat treatment in a solution state at 50°C for 4 hours to obtain an epoxy resin composition solution. The resulting composition was allowed to stand at 50°C for 20 days. As a result, thickening of the solution did not occur and thus the composition showed excellent storage stability. Subsequently, using the solution, a cured article of the epoxy resin composition was produced in the same manner as in Example 1. In Comparative Example 4, a cured article of an epoxy resin was produced in the same manner as in Example 13, except that a tetraethylenepentamine borate was not used and only dicyandiamide was used.

Using the cured films having a thickness of 300 µm obtained in examples and comparative examples, dynamic viscoelasticity (frequency: 1 Hz) and water absorption were measured. As a result, a peak temperature (Tg) of tan δ of the resulting cured film of Example 13 was 180°C. To the contrary, in Comparative Example 4, a peak temperature (Tg) of tan δ was 154°C. It is apparent that heat resistance of the epoxy resin cured article using a polyamine borate and dicyandiamide in combination is improved. Water absorption was 1.8% in Comparative Example 4, whereas, water absorption was 2.0% in Example 13. When using a polyamine borate and dicyandiamide in combination, heat resistance was improved, but water absorption scarcely increased. The evaluation results are shown in Table 9.

**Table 9**

| | | Example 13 | Comparative Example 4 |
|---|---|---|---|
| Epoxy resin composition | Epoxy resin D | EXA9101 | EXA9101 |
| | Weight (g) | 125 | 125 |
| | Epoxy equivalent (g/eq) | 368 | 368 |
| | Amine borate | 1d | - |
| | Weight (g) | 5 | - |
| | Amine content (g) | 2.34 | - |
| | Epoxy equivalent ratio (%) | 32 | - |
| | Boron content based on D (% by mass) | 0.4 | 0 |
| | Curing agent(C)/accelerator | DICY/2E4MZ | DICY/2E4MZ |
| | Weight (g) | 2.8/0.4 | 2.8/0.4 |
| | Epoxy equivalent ratio (%) | 50 | 50 |
| | Solvent (g) | MeOH 60 | DMF |
| | | DMF 80 | 140 |
| Heat treatment in solution state | | 50°C, 4 hrs | - |
| Storage stability⁽*⁾ | | 20 days /50°C | > 20 days /50°C |
| Cured article | Light transmittance (%) | 91 | 93 |
| | Tg (°C) | 180 | 154 |
| | Water absorption (%) | 2 | 1.8 |

| | | | |
|---|---|---|---|
| (*): In storage stability, the symbol ">" means that excellent fluidity was maintained even after allowed to stand for predetermined days described above. No symbol means that excellent fluidity and the like disappeared on aforementioned day (visually evaluated). | | | |

### (Examples 14 to 16)

An epoxy resin composition and a cured article were produced in the same manner as in Example 13, except that TD2090-60M was used in Example 14, m-PDA was used in Example 15 and 2E4MZ was used in Example 16. The evaluation results of the resulting cured articles are shown in Table 10.

**Table 10**

| | | Example 14 | Example 15 | Example 16 |
|---|---|---|---|---|
| Epoxy resin composition | Epoxy resin D | EXA9101 | EXA9101 | EXA9101 |
| | Weight (g) | 125 | 125 | 125 |
| | Epoxy equivalent (g/eq) | 368 | 368 | 368 |
| | Amine borate | 1a | 1a | 1d |
| | Weight (g) | 5 | 5 | 5 |
| | Amine content (g) | 2.34 | 2.34 | 2.34 |
| | Epoxy equivalent ratio (%) | 32 | 32 | 32 |
| | Boron content based on D (% by mass) | 0.4 | 0.4 | 0.4 |
| | Curing agent (C) | TD2090-60M | m-PDA | 2E4MZ |
| | Weight (g) | 33.4 | 3.6 | 2 |
| | Epoxy equivalent ratio (%) | 70 | 50 | 2 phr⁽*⁾ |
| | Solvent (g) | MeOH 80 MEK 80 | MeOH 80 MEK 80 | MeOH 80 MEK 80 |
| Heat treatment in solution state | | 50°C, 2 hrs | 50°C, 4 hrs | 50°C 3 hrs |
| Storage stability | | > 50 days/25°C | 10 days/25°C | > 20 days/50°C |
| Cured article | Light transmittance (%) | 88 | 92 | 90 |
| | Tg (°C) | 162 | 162 | 188 |
| | Water absorption (%) | 1.6 | 1.7 | 1.8 |

| | | | | |
|---|---|---|---|---|
| (*): The amount described in the column of an epoxy equivalent of Example 16 represents a compounded amount. | | | | |

### (Example 17)

In Example 17, an epoxy resin composition and a cured article thereof were produced in the same manner as in Example 13, except that a high-bromo bisphenol A type epoxy resin EPICLON 153-X (manufactured by DAINIPPON INK AND CHEMICALS, INCORPOREATED, epoxy equivalent: 396 g/eq, Br content: 48%) and a bisphenol A type epoxy resin EPICLON 850 were used. The evaluation results of the resulting cured article are shown in Table 11.

### (Example 18)

In Example 18, an epoxy resin composition and a cured article thereof were produced in the same manner as in Example 17, except that a tetraethylenepentamine condensed borate 2d was used. The evaluation results of the resulting cured article are shown in Table 11.

**Table 11**

| | | Example 17 | Example 18 |
|---|---|---|---|
| Epoxy resin composition | Epoxy resin D1 | 153X | 153X |
| | Weight (g) | 41.6 | 41.6 |
| | Epoxy equivalent (g/eq) | 396 | 396 |
| | Epoxy resin D2 | 850 | 850 |
| | Weight (g) | 58.4 | 58.4 |
| | Epoxy equivalent (g/eq) | 188 | 188 |
| | Br content (% by mass) | 20 | 20 |
| | Amine borate | 1d | 2d |
| | Weight (g) | 7.2 | 8.2 |
| | Amine content (g) | 3.4 | 3.4 |
| | Epoxy equivalent ratio (%) | 30 | 30 |
| | Boron content based on D (% by mass) | 0.58 | 1.56 |
| | Curing agent(C) | DICY | DICY |
| | Weight (g) | 4 | 4 |
| | Epoxy equivalent ratio(%) | 50 | 50 |
| | Solvent (g) | MeOH 60 | MeOH 60 |
| | | DMF 100 | DMF 100 |
| Heat treatment in solution state | | 50°C, 6 hrs | 50°C, 6 hrs |
| Storage stability | | > 20 days /50°C | > 20 days /50°C |
| Cured article | Light transmittance (%) | 91 | 90 |
| | Tg (°C) | 227 | 251 |
| | Water absorption (%) | 2.6 | 2.7 |

### (Example 19)

While stirring a solution prepared by dissolving 14.5 g of a tetraethylenepentamine condensed borate 1d in 33 g of methanol, 33 g of MEK was added dropwise. To the resulting transparent solution, 125 g of EPICLON 1121N-80M was added, followed by mixing with stirring and a heat treatment in a solution state at 80°C for 30 minutes to obtain a uniform transparent epoxy resin composition solution. Using the composition solution, a cured film was produced and a glass transition temperature as measured by dynamic viscoelasticity was 268°C. Subsequently, the composition solution was applied on a copper foil (32 micron thickness) using an applicator having a size of 0.25 mm and solvent-casted in an atmospheric air for 2 hours. After vacuum drying at 25°C for 13 hours, a copper foil provided with an uncured layer of a curable epoxy resin composition was obtained. The thickness of the uncured coating film layer was about 60 µm. A copper-cladded laminate was produced by laying the copper foil and a glass cloth resin molded plate one upon another and hot pressing under the conditions of 150°C and 100 MPa. The resulting copper-cladded laminate was subjected to a test on resistance to moisture and soldering in which the laminate is treated in steam at 121°C for 2 hours and ten dipped in a soldering bath at 260°C for 30 seconds. As a result, the laminate showed good resistance to moisture and soldering free from blister, bubbles and cracking.

### (Example 20)

While stirring a solution prepared by dissolving 10.8 g of a tetraethylenepentamine condensed borate 1d in 50 g of methanol, a solution of 6 g of dicyandiamide (DICY) and 50 g of DMF was added dropwise. To the resulting transparent solution, 87.6 g of EPICLON 850 and 62.4 g of EPICLON 153X were added, followed by mixing with stirring and a heat treatment in a solution state at 50°C for 6 hours to obtain a uniform transparent epoxy resin composition solution. Using the composition solution, a cured film was produced and a glass transition temperature as measured by dynamic viscoelasticity was 230°C. Subsequently, a copper cladded laminate was obtained in the same manner as in Example 19. The resulting copper-cladded laminate was subjected to a test on resistance to moisture and soldering in which the laminate is treated in steam at 121°C for 2 hours and ten dipped in a soldering bath at 260°C for 30 seconds. As a result, the laminate showed good resistance to moisture and soldering free from blister, bubbles and cracking.

### INDUSTRIAL APPLICABILITY

The polyamine borate used in the present invention is almost free from amine irritating odor and is freely soluble in methanol and also it is used as an effective curing agent for epoxy resin. As compared with the case of adding a boric acid-based compound as a controlling agent of curing characteristics, like the prior art, the boron content in the epoxy resin composition can be increased.

The epoxy resin composition of the present invention can provide a cured article having very high glass transition temperature by using the polyamine borate as a curing agent. Also it can impart mechanical properties such as elastic modulus and strength, heat characteristics such as low linear thermal expansion coefficient and high elastic modulus at high temperature, and excellent flame retardancy to the cured article.

The powdered thermosetting epoxy resin composition of the present invention using the polyamine borate is also excellent in storage stability and distribution/transportation properties.

Furthermore, the solution-like epoxy resin composition of the present invention obtained by using the polyamine borate in combination with an epoxy resin curing agent having long pot life has excellent moldability, moisture resistance and storage stability of prepreg which is no less excellent than a conventional material for laminate, and also can provide a heat-resistant copper-cladded laminate having improved glass transition temperature, mechanical properties, heat characteristics and flame retardancy.

## Claims

1. An epoxy resin composition comprising, as essential components, an epoxy resin having two or more epoxy groups in the molecule and a polyamine borate as a curing agent for the epoxy resin; wherein
the polyamine borate is obtained from a polyamine-based compound (A) having at least one of amino group and imino group in the molecule and a boric acid-based compound (B) represented by the following general formula (1):
B(OR)ₙ(OH)₃₋ₙ (1)
wherein n represents an integer of 0 to 3, R represents an alkyl group represented by CₘH₂ₘ₊₁, and m represents an integer of 1 to 10.

2. The epoxy resin composition according to claim 1, wherein the epoxy resin has an epoxy equivalent of 100 to 1000.

3. The epoxy resin composition according to claim 1, wherein the polyamine-based compound (A) is at least one of an aliphatic polyamine, an aromatic polyamine and an alicyclic polyamine.

4. The epoxy resin composition according to claim 1, wherein a ratio of the content of a nitrogen-containing group of the polyamine-based compound (A) to the content of boron of the boric acid-based compound (B) is from 1:1 to 1:6 in terms of a molar ratio.

5. The epoxy resin composition according to claim 1, wherein the content of the polyamine borate is from 4 to 120 parts by mass based on 100 parts by mass of the epoxy resin.

6. The epoxy resin composition according to claim 1, wherein the content of boron in the polyamine borate is from 0.2 to 10 parts by mass based on 100 parts by mass of the epoxy resin.

7. The epoxy resin composition according to claim 1, which is produced by uniformly dissolving the epoxy resin and the polyamine borate in a solvent containing a lower alcohol.

8. The epoxy resin composition according to claim 1, which further comprises, as the curing agent for epoxy resin, a curing agent other than the polyamine borate.

9. The epoxy resin composition according to claim 1, wherein a curing agent other than the polyamine borate is included, and it is at least one selected from dicyandiamide, an aromatic polyamine, a phenol novolak resin and an imidazole compound.

10. A method for producing a nongel-like epoxy resin composition, which comprises: heat-treating the epoxy resin composition according to claim 7 in a solution state without being gelled.

11. A method for producing a nongel-like epoxy resin composition, which comprises: preparing the polyamine borate and the epoxy resin described in claim 1; and uniformly microdispersing the polyamine borate in the epoxy resin or a epoxy resin solution, which is obtained by diluting the epoxy resin with a solvent.

12. A method for producing an epoxy resin composition, which comprises: drying the nongel-like thermosetting resin composition obtained in claim 10 or 11 at a low temperature of 100°C or lower so as to prevent a curing reaction from proceeding, thereby to remove the solvent included.

13. A method for producing a powdered epoxy resin composition, which comprises: grinding a solid obtained in claim 12.

14. A method for producing a molded article, which comprises: curing the powdered epoxy resin composition obtained in claim 13 by compression-molding under heating.

15. A method for producing a heat-resistant laminate sheet, which comprises: forming an uncured coating film layer of the epoxy resin composition according to claim 1 on the surface of a heat-resistant substrate sheet; laying another heat-resistant substrate sheet on the uncured coating film layer; and curing the uncured coating film layer after thermal contact bonding of both heat-resistant substrate sheets.

16. The method for producing a heat-resistant laminate sheet according to claim 15, wherein the heat-resistant laminate sheet is a copper-cladded laminate.
